# EUROPÄISCHE PATENTSCHRIFT

(11) **EP 2 272 105 B1**
(45) Veröffentlichungstag und Bekanntmachung des Hinweises auf die Patenterteilung: **06.04.2016**
(21) Anmeldenummer: 09737749.3
(22) Anmeldetag: 28.04.2009
(51) Int. Cl.: H01L 33/38, H01L 33/64, H01L 33/42, H01L 33/46

(54) **LEUCHTDIODENCHIP**
LIGHT-EMITTING DIODE CHIP
PUCE DE DIODE ÉLECTROLUMINESCENTE

(30) Priorität: 30.04.2008 DE 102008021675; 31.07.2008 DE 102008035900
(43) Veröffentlichungstag der Anmeldung: 12.01.2011
(60) Teilanmeldung: 16154306.1
(73) Patentinhaber: OSRAM Opto Semiconductors GmbH, 93055 Regensburg (DE)
(72) Erfinder: SABATHIL, Matthias, 93059 Regensburg (DE); HÖPPEL, Lutz, 93087 Alteglofsheim (DE); WEIMAR, Andreas, 93055 Regensburg (DE); ENGL, Karl, 93080 Niedergebraching (DE); BAUR, Johannes, 93051 Regensburg (DE)
(74) Vertreter: Epping - Hermann - Fischer
(86) Internationale Anmeldenummer: PCT/DE2009/000629
(87) Internationale Veröffentlichungsnummer: WO 2009/132641

(56) Entgegenhaltungen:
- WO-A-2005/013382
- DE-A1-102004 061 865
- US-A- 5 917 202
- US-A1- 2003 111 667
- US-A1- 2005 087 884
- US-A1- 2006 273 335
- US-A1- 2008 093 612

## Beschreibung

Die Lichtausbeute von Leuchtdiodenchips wird durch verschiedene Faktoren beeinflusst. Mittels einer geeigneten elektrischen Kontaktierung des Leuchtdiodenchips kann eine gute interne Quanteneffizienz erzielt werden. Gleichzeitig stellt die Kontaktierung jedoch eine mögliche Absorptionsquelle für die erzeugte Strahlung dar. Dies führt zu einer Limitierung der Auskoppeleffizienz und damit der Lichtausbeute des Leuchtdiodenchips.

Beispielsweise sind aus den Druckschriften WO 2005/013382 A, US 2006/273335 A1, US 5,917,202 A, US 2005/087884 A1, US 2003/111667 A1, US 2008/093612 A1 und DE 10 2004 061865 A1 LEDs mit Stromaufweitungsschichten bekannt.

Eine zu lösende Aufgabe besteht darin, die Lichtausbeute von Leuchtdiodenchips zu steigern.

Es wird ein Leuchtdiodenchip gemäß Anspruch 1 mit einer Halbleiterschichtenfolge angegeben, die eine aktive Zone zur Erzeugung von elektromagnetischer Strahlung aufweist. Zur Strahlungserzeugung wird die Halbleiterschichtenfolge elektrisch kontaktiert. Auf der Halbleiterschichtenfolge ist eine Stromaufweitungsschicht aufgebracht, die mittels Kontakten elektrisch kontaktiert wird. Die Kontakte bedecken 1 % - 8 % der Stromaufweitungsschicht, besonders bevorzugt bedecken sie 2% - 4 % der Stromaufweitungsschicht.

Bei der Kontaktierung der Halbleiterschichtenfolge über eine Stromaufweitungsschicht kann eine besonders gleichmäßige Stromverteilung erzielt werden. Die Absorption der Strahlung an den Kontakten wird durch die geringe Kontaktfläche minimiert. Ein Bedeckungsgrad von 1 % - 8 % und insbesondere von 2 % - 4 % stellt einen guten Kompromiss zwischen ausreichender Stromzufuhr und vertretbarer Absorption dar.

In der vorliegenden Erfindung bezieht sich die Flächenbelegung der Halbleiterschichtenfolge auf die Summe der Querschnittsflächen der Kontakte an der Grenzfläche zur Stromaufweitungsschicht.

Die Ladungsträger werden über die Kontakte in die Stromaufweitungsschicht injiziert und in der Stromaufweitungsschicht lateral gleichmäßig verteilt. Von der Stromaufweitungsschicht treten sie in die Halbleiterschicht ein. Eine p-dotierte Halbleiterschicht weist meist nur eine geringe Querleitfähigkeit auf und kann deshalb nur eine ungenügende laterale Verteilung der Ladungsträger bewerkstelligen. Deshalb ist es hier besonders vorteilhaft, wenn die Ladungsträger mittels einer Stromaufweitungsschicht lateral gleichmäßig verteilt werden, bevor sie in die Halbleiterschicht injiziert werden.

Vorzugsweise sind die Kontakte gleichmäßig über die Fläche der Stromaufweitungsschicht verteilt.

Daraus ergibt sich eine besonders gleichmäßige laterale Verteilung der Ladungsträger in der Stromaufweitungsschicht.

In einer vorteilhaften Ausführungsform sind die Kontakte als separate Kontaktpunkte ausgeführt. Ein Kontakt wird als Kontaktpunkt bezeichnet, wenn er die Stromaufweitungsschicht nur punktartig bedeckt.

Vorzugsweise sind die Kontaktpunkte über die Fläche der Stromaufweitungsschicht gleichmäßig verteilt.

In einer bevorzugten Ausführungsform sind benachbarte Kontaktpunkte im Abstand von weniger als 30 µm, insbesondere von weniger oder gleich 12 µm angeordnet.

Beispielsweise sind die Kontakte an Knotenpunkten eines regelmäßigen Gitters angeordnet. Vorzugsweise ist die Gitterkonstante des Gitters kleiner als 30 µm. Besonders vorteilhaft ist es, wenn die Gitterkonstante kleiner oder gleich 12 µm ist.

Dabei entspricht die Gitterkonstante dem Abstand benachbarter Kontaktpunkte. Vorzugsweise nimmt die Querschnittsfläche der einzelnen Kontaktpunkte mit abnehmender Gitterkonstante ebenfalls ab. Dadurch wird sichergestellt, dass die Kontakte auch bei einer kleineren Gitterkonstante insgesamt nur 1 % - 8 % und besonders bevorzugt nur 2 % - 4 % der Fläche der Stromaufweitungsschicht bedecken. Die Fläche eines Kontaktpunktes ergibt sich direkt aus dem Kontaktabstand und der mittleren Flächenbelegung.

In einer vorteilhaften Ausgestaltungsform ist an der Grenzfläche zwischen der Stromaufweitungsschicht und den Kontakten ein Freibereich ausgebildet, in dem die Stromaufweitungsschicht nicht von Kontakten bedeckt ist. Die Flächenbelegung des Freibereichs ist beispielsweise ähnlich groß wie die Flächenbelegung der Kontakte. Sind die Kontakte an den Knotenpunkten eines regelmäßigen Gitters angeordnet, so sind die im Freibereich liegenden Knotenpunkte des Gitters frei von Kontakten. Beispielsweise ist in diesem Fall der Freibereich so groß wie der Bereich der Stromaufweitungsschicht, in dem die Knotenpunkte des Gitters frei von Kontakten sind. In einer Ausführungsform weist der Freibereich eine Rahmenform auf und umgibt die Kontakte. Beispielsweise liegt die Breite eines Rahmenabschnitts im Bereich von wenigstens 1 µm bis höchstens 10 µm.

Der Freibereich ist vorzugsweise in einem Bereich ausgebildet, in dem ein besonders großer Anteil der erzeugten Strahlung auftrifft, da somit die Absorption der Strahlung besonders wirkungsvoll reduziert werden kann. In einem zentralen Bereich der aktiven Zone der Halbleiterschichtenfolge wird der größte Anteil der Strahlung erzeugt. Deshalb trifft auch auf einen Bereich der Stromaufweitungsschicht, der sich senkrecht unter diesem zentralen Bereich befindet, besonders viel Strahlung auf. Deshalb ist dort die Ausbildung eines Freibereichs besonders günstig. Die Fläche des Freibereichs ist vorzugsweise so gewählt, dass eine möglichst gleichmäßige Stromverteilung sichergestellt ist.

In der vorliegenden Erfindung sind die Kontakte so ausgebildet, dass ihre Wärmeleitfähigkeit mit zunehmendem Abstand von der Halbleiterschichtenfolge zunimmt.

Dadurch kann erreicht werden, dass die Kontakte die in der aktiven Zone erzeugte Wärme gut abführen, ohne dass sie zu einer hohen Absorption der Strahlung führen. In der Nähe der Halbleiterschichtenfolge weisen die Kontakte ein geringes Absorptionsvermögen für die erzeugte Strahlung auf. Dies geht zumeist mit einer geringen Wärmeleitfähigkeit einher. Beispielsweise sind die Kontakte an der Grenze zur Stromaufweitungsschicht verspiegelt. Mit zunehmendem Abstand von der Halbleiterschichtenfolge trifft aufgrund der Reflexion und der Absorption der Strahlung an den Kontakten oder weiteren Bestandteilen des Leuchtdiodenchips ein geringerer Anteil der Strahlung auf. Deshalb muss hier bei der Ausgestaltung der Kontakte weniger Rücksicht auf die Absorption der Strahlung genommen werden und die Kontakte können hinsichtlich ihrer Wärmeleitfähigkeit optimiert werden.

Eine Erhöhung der Wärmeleitfähigkeit mit zunehmendem Abstand von der Halbleiterschichtenfolge wird durch eine Zunahme der Querschnittsflächen der Kontakte erreicht. Beispielsweise haben die Kontakte eine konische Form.

Vorzugsweise grenzt eine dielektrische Schicht an die Seite der Stromaufweitungsschicht an, die von der Halbleiterschichtenfolge abgewandt ist. Da die dielektrische Schicht nur eine geringe elektrische Leitfähigkeit aufweist, werden die Kontakte durch sie hindurchgeführt und stehen in elektrischem Kontakt mit der Stromaufweitungsschicht.

Die dielektrische Schicht dient dazu, die auftreffende Strahlung möglichst verlustfrei in die Halbleiterschichtenfolge zurückzureflektieren. Die reflektierte Strahlung kann dann den Leuchtdiodenchip beispielsweise durch einen oberen Auskoppelbereich verlassen. Die dielektrische Schicht erhöht somit die Auskoppeleffizienz des Leuchtdiodenchips. Dies ist besonders vorteilhaft für Dünnfilm-Leuchtdiodenchips oder bei einem Flipchip-Aufbau.

Die dielektrische Schicht ist beispielsweise als Bragg-Spiegel ausgeführt, bei dem dielektrische Teilschichten mit hohem und niedrigem Brechungsindex alternierend angeordnet sind.

In einer vorteilhaften Ausführungsform weist die dielektrische Schicht einen besonders niedrigen Brechungsindex auf. Dadurch wird ein möglichst großer Teil der Strahlung reflektiert. Beispielsweise enthält die dielektrische Schicht ein low-k- oder ein ultra low-k-Material. Die dielektrische Schicht kann auch eine Luftschicht sein. Das bedeutet, die Kontakte können zumindest stellenweise von einer Luftschicht umgeben sein.

In einer Ausführungsform des Leuchtdiodenchips befindet sich eine Metallschicht auf der Seite der dielektrischen Schicht, die von der Halbleiterschichtenfolge abgewandt ist. Vorzugsweise grenzen die Kontakte an die Metallschicht an.

Durch die Metallschicht kann der Teil der Strahlung, der nicht von der dielektrischen Schicht reflektiert wurde, in die Halbleiterschichtenfolge zurückreflektiert werden.

In einer Ausführungsform weist der Leuchtdiodenchip einen elektrisch leitfähigen Träger auf. In diesem Fall kann die Halbeiterschichtenfolge mittels eines unteren Kontaktes elektrisch angeschlossen werden, der sich auf der Außenseite des Trägers befindet. Dabei können die Ladungsträger über den unteren Kontakt, den Träger, die Metallschicht, die Kontakte und die Stromaufweitungsschicht in die Halbleiterschichtenfolge injiziert werden.

In einer vorteilhaften Ausführungsform des Leuchtdiodenchips ist die Stromaufweitungsschicht so ausgebildet, dass sie einen möglichst geringen Anteil der erzeugten Strahlung absorbiert. Dabei muss jedoch eine gleichmäßige Stromverteilung sichergestellt sein.

Die Erfinder haben festgestellt, dass eine Stromaufweitungsschicht mit einer Dicke im Bereich von 10 nm bis 60 nm einen guten Kompromiss zwischen Minimierung der Absorption und Maximierung der Querleitfähigkeit darstellt.

Dabei hängt die optimale Dicke der Stromaufweitungsschicht auch vom verwendeten Material ab. Beispielsweise enthält die Stromaufweitungsschicht ein transparentes leitfähiges Oxid (TCO) wie Indiumzinnoxid (ITO), Indiumzinkoxid (IZO) oder Zinkoxid (ZnO).

Vorzugweise weist eine ITO-Schicht eine Dicke von mindestens 30 nm, eine IZO-Schicht eine Dicke von mindestens 15 nm und eine ZnO-Schicht eine Dicke von mindestens 40 nm auf.

In einer besonders vorteilhaften Ausführungsform des Leuchtdiodenchips sind sowohl die Anordnung der Kontakte, die Form der Kontakte, die Dicke der Stromaufweitungsschicht und das Material der Stromaufweitungsschicht aufeinander abgestimmt und optimiert. Beispielsweise kann bei einem geringeren Abstand der Kontakte die Dicke der Stromaufweitungsschicht reduziert werden.

Im Folgenden werden der angegebene Halbleiterchip und seine vorteilhaften Ausgestaltungen anhand von schematischen und nicht maßstabsgetreuen Figuren erläutert. Es zeigen:
- Figur 1A: im Querschnitt einen Leuchtdiodenchip mit elektrischen Kontakten, die an eine Stromaufweitungsschicht angrenzen,
- Figur 1B: eine weitere Ausführungsform für einen Leuchtdiodenchip mit elektrischen Kontakten, die an eine Stromaufweitungsschicht angrenzen,
- Figur 2A: in der Aufsicht ein regelmäßiges Gitter, an dessen Knotenpunkten Kontaktpunkte angeordnet sind,
- Figur 2B: im Querschnitt konische Kontakte, die durch eine dielektrische Spiegelschicht führen,
- Figur 3A: im Liniendiagramm die Verlustleistung aufgrund der Absorption der erzeugten Strahlung an den Kontakten in Abhängigkeit von der Flächenbelegung der Kontakte,
- Figur 3B: im Liniendiagramm die Verlustleistung aufgrund der Absorption und des Widerstands der Kontakte in Abhängigkeit von der Flächenbelegung der Kontakte,
- Figur 4A: im Liniendiagramm die Optimierung des Kontaktabstands für verschiedene Stromaufweitungsschichten,
- Figur 4B: im Liniendiagramm die thermischen Widerstände von Kontakten, die durch dielektrische Schichten führen, in Abhängigkeit vom Kontaktabstand,
- Figur 5: in der Aufsicht verschiedene Ausführungsmöglichkeiten für die Anordnung von Kontakten an den Knotenpunkten regelmäßiger Gitter und die sich ergebenden Auskoppeleffizienzen,
- Figur 6A: im Liniendiagramm die Querleitfähigkeit verschiedener TCO-Materialien in Abhängigkeit von der Dicke der TCO-Schicht,
- Figur 6B: im Liniendiagramm die Auskoppeleffizienzen bei verschiedenen TCO-Materialien und für verschiedene Wellenlängen der Strahlung in Abhängigkeit von der Dicke der TCO-Schicht.

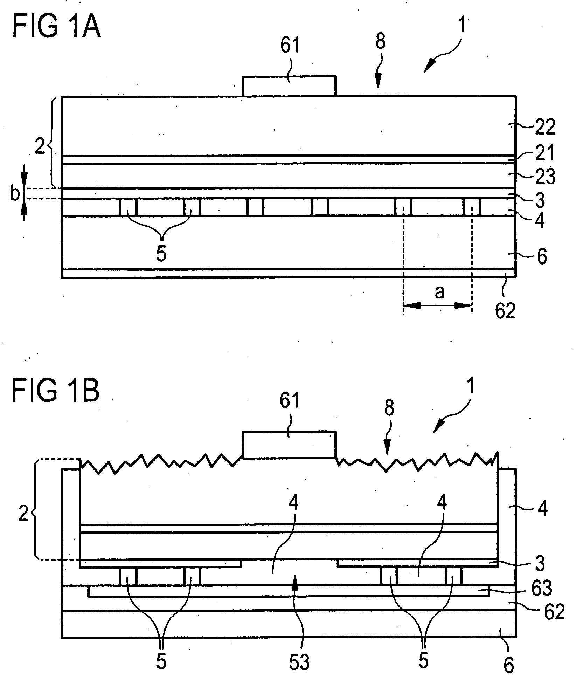

Figur 1A zeigt einen Leuchtdiodenchip 1, der eine Halbleiterschichtenfolge 2 mit einer aktiven Zone 21 zur Erzeugung von elektromagnetischer Strahlung aufweist. Die aktive Zone 21 befindet sich zwischen zwei Halbleiterschichten 22, 23. In diesem Ausführungsbeispiel ist die Halbleiterschicht 23 p-dotiert, die Halbleiterschicht 22 n-dotiert. Die Halbleiterschichten 22, 23 basieren beispielsweise auf Galliumnitrid, die aktive Zone 21 auf Indiumgalliumnitrid.

Die Halbleiterschichten 21, 22, 23 können epitaktisch aufgewachsen sein und vorzugsweise eine Gesamtdicke von weniger als 20 µm, insbesondere von weniger als 10 µm aufweisen. Insbesondere kann der Leuchtdiodenchip 1 ein Dünnfilm-Leuchtdiodenchip sein.

Zur elektrischen Kontaktierung des Leuchtdiodenchips sind ein oberer 61 und ein unterer Kontakt 62 vorgesehen. Beispielsweise ist der obere Kontakt 61 als Bondpad ausgeführt und mit einem Bonddraht verbunden (nicht gezeigt). Der untere Kontakt 62 ist beispielsweise mit einer Leiterbahnstruktur einer Leiterplatte verbunden (nicht gezeigt).

Der untere Kontakt 62 ist auf der Außenseite eines Trägers 6 des Leuchtdiodenchips 1 angeordnet. Der Träger 6 ist elektrisch leitfähig und umfasst beispielsweise Halbleitermaterialien, wie Silizium, Siliziumcarbid, Galliumarsenid, Galliumnitrid oder Germanium.

In einer alternativen Ausführungsform kann der Träger 6 auch aus einem nicht leitfähigen Material bestehen. Dann sind die Kontakte 5 vorzugsweise durch den Träger 6 hindurchgeführt.

Mittels Kontakten 5 wird eine elektrische Verbindung zwischen dem Träger 6 und der Halbleiterschichtenfolge 2 hergestellt. Die Kontakte 5 grenzen an eine Stromaufweitungsschicht 3, die ihrerseits an die p-dotierte Halbleiterschicht 23 angrenzt. In anderen Ausführungsformen können die Kontakte 5 auch in die Stromaufweitungsschicht 3 hineinragen.

Die Kontakte 5 sind gleichmäßig über die Fläche der Halbleiterschichtenfolge 2 verteilt. Der Abstand a zweier benachbarter Kontakte 5 ist vorzugsweise geringer als 24 µm, besonders bevorzugt geringer als 12 µm.

Die Stromaufweitungsschicht 3 weist vorzugsweise eine Dicke b im Bereich von 10 nm bis 60 nm auf. Sie enthält ein transparentes leitfähiges Oxid (TCO), beispielsweise Indiumzinnoxid (ITO), Indiumzinkoxid (IZO) oder Zinkoxid (ZnO). Die Stromaufweitungsschicht 3 ist beispielsweise auf die Halbleiterschicht 23 aufgesputtert.

Zwischen der Stromaufweitungsschicht 3 und dem Träger 6 befindet sich eine dielektrische Schicht 4, durch die die Kontakte 5 hindurchgeführt sind. Die dielektrische Schicht 4 dient dazu, auftreffende Strahlung zurück in die Halbleiterschichtenfolge 2 zu reflektieren, so dass diese durch einen oberen Auskoppelbereich 8 den Leuchtdiodenchip 1 verlassen kann. Die dielektrische Schicht 4 enthält beispielsweise Siliziumdioxid. In weiteren Ausführungsformen kann die dielektrische Schicht 4 ein Material enthalten, das einen besonders niedrigen Brechungsindex aufweist. Insbesondere kann die dielektrische Schicht 4 auch eine Luftschicht sein.

Zur Ausbildung der Kontakte 5 können in einem fotolithografischen Prozess Ausnehmungen in die dielektrische Schicht 4 eingebracht und mit einem leitfähigen Material, beispielsweise einem Metall, gefüllt werden.

Figur 1B zeigt eine weitere Ausführungsform für einen Leuchtdiodenchip 1. Hier ist ein Freibereich 53 ausgebildet, in dem die Halbleiterschichtenfolge 2 nicht von Kontakten 5 bedeckt ist. Der Freibereich 53 ist mittig bezüglich der Fläche der Halbleiterschichtenfolge 2 angeordnet. Da in einem zentralen Bereich der aktiven Zone 21 auch der größte Anteil der Strahlung erzeugt wird, trifft dort am meisten Strahlung auf. Durch die zentrale Anordnung des Freibereichs 53 kann somit die Absorption der Strahlung an den Kontakten 5 besonders wirkungsvoll reduziert werden.

Zudem führt die dielektrische Schicht 4 in einem zentralen Bereich durch die Stromaufweitungsschicht 3 hindurch und grenzt direkt an die p-dotierte Halbleiterschicht 23 an. Dies führt dazu, dass die Absorption der Strahlung in der Stromaufweitungsschicht 3 gerade in diesem zentralen Bereich reduziert wird.

Die dielektrische Schicht 4 wird in Richtung des Trägers 6 durch eine Metallschicht 63 abgeschlossen. Die Metallschicht 63 ist dazu geeignet, Strahlung, die von der dielektrischen Schicht 4 nicht reflektiert wurde, in die Halbleiterschichtenfolge 2 zurückzureflektieren. Die Metallschicht 63 ist beispielsweise durch Aufsputtern, Aufdampfen oder mittels galvanischer Abscheidung auf die dielektrische Schicht 4 aufgebracht. Die Kontakte 5 stehen mit der Metallschicht 63 in elektrischem Kontakt. Die Metallschicht 63 wird durch eine weitere metallische Schicht 62 gekapselt.

Zudem ist in diesem Ausführungsbeispiel der obere Auskoppelbereich 8 aufgeraut. Dadurch wird die Auskoppeleffizienz verbessert. Die dielektrische Schicht 4 ist auch seitlich auf der Halbleiterschichtenfolge 2 angeordnet. Dies dient der elektrischen Isolierung des Leuchtdiodenchips 1.

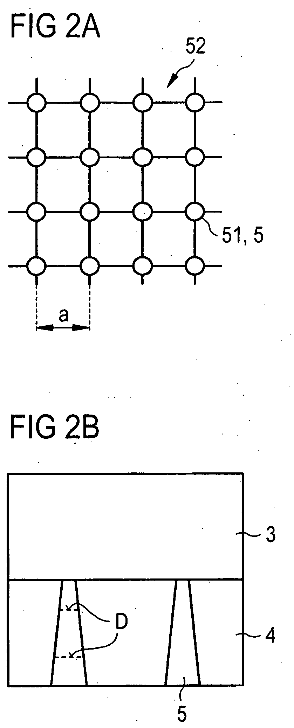

Figur 2A zeigt in der Aufsicht ein regelmäßiges Gitter 52, an dessen Knotenpunkten Kontakte 5 in Form separater Kontaktpunkte 51 angeordnet sind. Der Abstand a zweier benachbarter Kontaktpunkte 51 entspricht der Gitterkonstante des Gitters 52.

Figur 2B zeigt im Querschnitt Kontakte 5, die durch eine dielektrische Spiegelschicht 4 hindurchgeführt sind und eine konische Form aufweisen. Mit zunehmendem Abstand von der Stromaufweitungsschicht 3 und damit auch von der Halbleiterschichtenfolge 2 nimmt die Querschnittsfläche D der Kontakte 5 zu. Dies führt dazu, dass die Wärmeleitfähigkeit der Kontakte 5 mit zunehmendem Abstand von der Stromaufweitungsschicht 3 zunimmt. In der Nähe der Stromaufweitungsschicht 3 weisen die Kontakte 5 eine kleinere Querschnittsfläche D und damit eine geringeres Absorptionsvermögen für die auftreffende Strahlung auf.

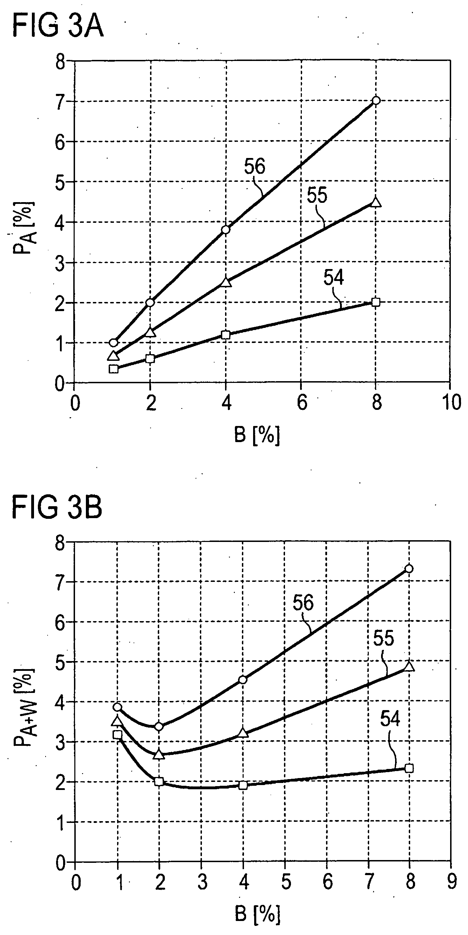

Die Figuren 3A und 3B zeigen eine Optimierung der Kontakte hinsichtlich ihrer Flächenbelegung.

In Figur 3A ist für Kontakte aus verschiedenen Materialien 54, 55, 56 die Verlustleistung P_{A} aufgrund der Absorption der Strahlung an den Kontakten gegen die Flächenbelegung B der Kontakte aufgetragen. Die Verlustleistung P_{A} wurde für optimale Silberkontakte 54, reale Silberkontakte 55 und Aluminiumkontakte mit einer 1,0 nm dicken Haftschicht aus Titan 56 berechnet. Bei den realen Silberkontakten 55 ist im Gegensatz zu den optimalen Silberkontakten 54 berücksichtigt, dass die Rauheit der Oberfläche zu zusätzlichen Absorptionsverlusten führt.

Aus Figur 3A geht hervor, dass die Verlustleistung P_{A} für alle Kontaktmaterialien 54, 55, 56 mit wachsender Flächenbelegung B zunimmt. Insgesamt ist die Absorption der Strahlung an den optimalen Silberkontakten 54 am geringsten. Für die realen Silberkontakte 55 ergibt sich eine etwas größere Absorption und für die Aluminiumkontakte mit Titanhaftschicht 56 die größte Absorption.

Bei der Berechnung wurde angenommen, dass die Kontakte an den Knotenpunkten eines regelmäßigen Gitters mit einer Gitterkonstante von 12,5 µm angeordnet sind. Die in der aktiven Zone 21 erzeugte Strahlung weist eine Wellenlänge von 460 nm auf.

In Figur 3B ist die Verlustleistung P_{A+W} eines Leuchtdiodenchips aufgetragen, die aufgrund der Absorption der Strahlung an den Kontakten und aufgrund des elektrischen Widerstandes zwischen der Stromaufweitungsschicht und den Kontakten entsteht. Die Verlustleistung P_{A+W} wurde als Funktion der Flächenbelegung B der Kontakte berechnet.

Dabei wurden wieder Kontakte aus den Kontaktmaterialien 54, 55, 56 gemäß Figur 3A betrachtet. Auch hier ergibt sich für die optimalen Silberkontakte 54 im gesamten Bereich der Flächenbelegung B die geringste Verlustleistung P_{A+W}, für die realen Silberkontakte 55 eine etwas höhere Verlustleistung P_{A+W} und für die Aluminiumkontakte mit Titanhaftschicht 56 die größte Verlustleistung, P_{A+W}. Für alle Kontaktmaterialien 54, 55, 56 wird bei einer Flächenbelegung im Bereich von 2% - 4 % ein Minimum in der Verlustleistung P_{A+W} erreicht. Daraus ergibt sich der optimale Wert für die Flächenbelegung der Kontakte.

Den Berechnungen ist eine Stromzufuhr von 2 A/mm² und ein spezifischer Kontaktwiderstand ρ_{K} einer Anordnung aus TCO-Schicht und Kontakten von 5 x 10⁻¹⁰ Ω m² zugrunde gelegt. Der Kontaktwiderstand der Anordnung ergibt sich aus dem Quotienten des spezifischen Kontaktwiderstandes und der Grundfläche der Anordnung. Durch eine Vorbehandlung der TCO-Schicht kann dieser Kontaktwiderstand weiter reduziert werden.

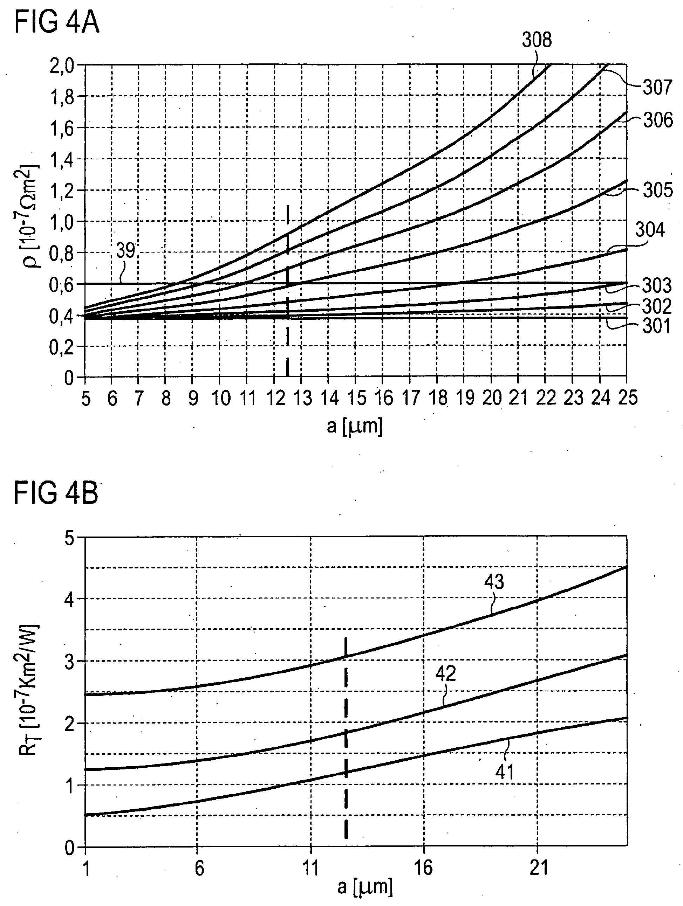

Figur 4A zeigt die Optimierung des Abstandes a benachbarter Kontaktpunkte bei einer festen Flächenbelegung der Kontakte. Dazu wurde der spezifische Kontaktwiderstand ρ_{K} einer Anordnung aus p-dotierter Galliumnitridschicht, TCO-Schicht und Kontakten in Abhängigkeit vom Kontaktabstand a berechnet. Es wurden verschiedene TCO-Schichten 301, 302, 303, 304, 305, 306, 307, 308 mit den Flächenwiderständen ρₛ = 50, 100, 200, 400, 800, 1200, 1600 und 2000 Ω/sq betrachtet. Der Flächenwiderstand ρₛ entspricht dem Widerstand einer dünnen quadratischen Schicht, bei der der Stromfluss zwischen zwei Elektroden erfolgt, die an gegenüberliegenden Kanten der Schicht angeordnet sind. Zur Verdeutlichung, dass es sich bei ρₛ um den Flächenwiderstand einer dünnen quadratischen Schicht handelt, erhält er üblicherweise die Einheit Ω/sq. Die Berechnung wurde für Kontaktpunkte durchgeführt, die an den Knotenpunkten eines quadratischen Gitters mit der Gitterkonstante a angeordnet sind.

Hin zu kleinen Kontaktabständen a nähern sich die spezifischen Kontaktwiderstände ρ_{K} der Anordnungen einem Wert von zirka 4 x 10⁻⁸ Ω m² an. Dieser Wert entspricht dem spezifischen Kontaktwiderstand ρ_{K} zwischen der Halbleiterschicht und der TCO-Schicht, sowie zwischen der TCO-Schicht und den Kontakten. Für größere Kontaktabstände steigt der spezifische Kontaktwiderstand ρ_{K} aufgrund der Stromaufweitung in der TCO-Schicht an.

Dabei sollte der spezifische Kontaktwiderstand ρ_{K} nicht zu groß werden, da sonst die Effizienz des Leuchtdiodenchips beeinträchtigt wird. Die Erfinder haben festgestellt, dass ρ_{K} durch die Stromaufweitung um maximal 50 % ansteigen sollte. Dies entspricht einem maximalen spezifischen Kontaktwiderstand ρ_{K} von zirka 6 x 10⁻⁸ Ω m², der durch eine horizontale Linie 39 in Figur 4A kenntlich gemacht ist. Für eine TCO-Schicht mit dem Flächenwiderstand ρₛ = 800 Ω/sq (Kurve 305) ergibt sich aus dem Schnittpunkt der Kurve 305 mit dem maximalen spezifischen Kontaktwiderstand ρ_{K} 39 ein maximaler Kontaktabstand a von zirka 12,5 µm.

In Figur 4B ist der thermische Widerstand R_{T} einer Anordnung aus dielektrischer Schicht mit durchgeführten Kontakten in Abhängigkeit vom Kontaktabstand a aufgetragen.

In der Anordnung gemäß Figur 1A wird die in der aktiven Zone 21 erzeugte Wärme über die p-dotierte Halbleiterschicht 23, die Kontakte 5 und den Träger 6 abgeführt. Die dielektrische Schicht 4 trägt aufgrund ihrer geringen Wärmeleitfähigkeit nur wenig zur Ableitung der Wärme bei. Beispielsweise liegt für eine dielektrische Schicht 4 aus Siliziumdioxid die Wärmeleitfähigkeit im Bereich von 1 W/mK. Die Kontakte 5 weisen vorzugsweise eine hohe Wärmeleitfähigkeit auf. Für Silberkontakte ergibt sich eine Wärmeleitfähigkeit von zirka 400 W/mK. Die Halbleiterschicht weist eine Wärmeleitfähigkeit von zirka 130 W/mK auf.

In Figur 4B wurde der thermische Widerstand R_{T} für dielektrische Schichten aus Siliziumdioxid mit den Dicken 400 nm (Kurve 41), 1000 nm (Kurve 42) und 2000 nm (Kurve 43) berechnet. Die Flächenbelegung der Kontakte beträgt dabei jeweils 2,5 % der Halbleiterschicht. Die Halbleiterschicht weist eine Dicke von 4 µm auf.

Für Kontaktabstände a < 6 µm ergibt sich jeweils ein Plateau im thermischen Widerstand R_{T}, das im Wesentlichen die Flächenbelegung und die thermische Leitfähigkeit der Kontakte widerspiegelt. Hin zu größeren Kontaktabständen nimmt der thermische Widerstand R_{T} aufgrund der Wärmespreizung in der Halbleiterschicht zu. Bei dem aus Figur 4A abgeleiteten Kontaktabstand a im Bereich von 12,5 µm ist für reale Silberkontakte 42 und für Aluminiumkontakte mit einer Titanhaftschicht 43 die Zunahme des thermischen Widerstands R_{T} aufgrund der Wärmespreizung geringer als 50% des Plateauwertes. Dadurch erweist sich ein Kontaktabstand a von 12,5 µm auch als günstig im Hinblick auf die thermische Leitfähigkeit.

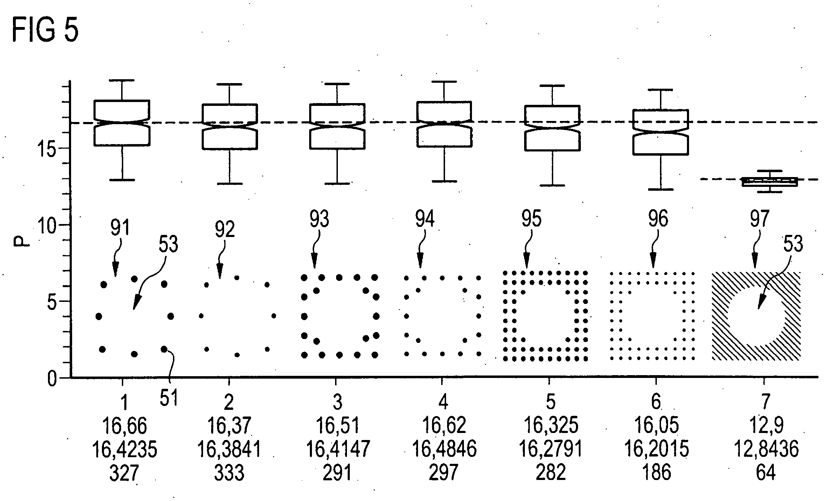

Figur 5 zeigt in der Aufsicht verschiedene Ausführungsformen 91, 92, 93, 94, 95, 96 für Kontakte, die an den Knotenpunkten regelmäßiger Gitter 52 angeordnet sind. Dabei weisen die Anordnungen 91 und 92 identische Gitterkonstanten, jedoch unterschiedliche Flächenbelegungen der Kontakte auf. Dies gilt ebenso für die Anordnungen 93 und 94, sowie die Anordnungen 95 und 96. Alle Kontaktstrukturen 91 - 96 weisen einen Freibereich 53 auf, an dem benachbarte Knotenpunkte nicht von Kontaktpunkten 51 besetzt sind. Zudem ist eine flächige Kontaktstruktur 97 dargestellt, die ebenfalls einen Freibereich 53 aufweist.

Für die gezeigten Anordnungen 91 - 97 wurden die abgestrahlten Lichtleistungen P gemessen. Dabei wurde für jede Anordnung eine Reihe von Bauteilen vermessen und ein Mittelwert gebildet. Die Messergebnisse sind jeweils oberhalb der gezeigten Anordnungen 91 - 97 in Skaleneinheiten aufgetragen. Unterhalb der Anordnungen sind jeweils der Median, der Mittelwert und die Anzahl der vermessenen Bauteile angegeben. Aus Figur 5 geht hervor, dass die mittleren Lichtleistungen P der punktförmigen Kontaktstrukturen 91 - 96 um zirka 30 % über der Lichtleistung des flächigen Kontakts 97 liegen.

In den vermessenen Anordnungen sind die Kontaktstrukturen nicht mit einer Stromaufweitungsschicht, sondern direkt mit einer Halbleiterschicht verbunden.

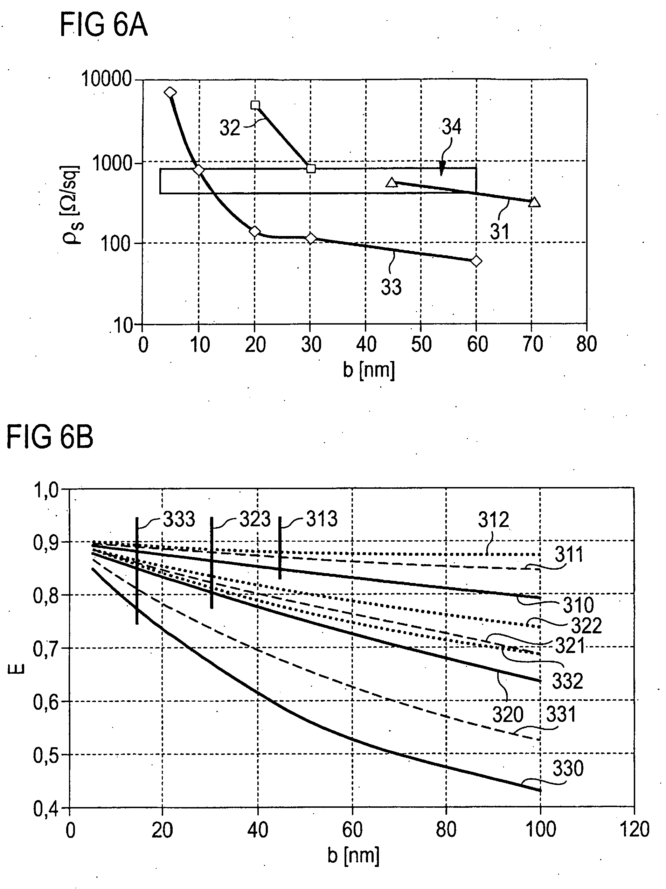

In Figur 6A sind die Flächenwiderstände ρₛ von Stromaufweitungsschichten aus ZnO 31, ITO 32 und IZO 33 in Abhängigkeit von der jeweiligen Schichtdicke b aufgetragen. Wie aus der Figur hervorgeht, kann für alle TCO-Schichten 31, 32, 33 ein Flächenwiderstand ρₛ in einem Bereich 34 um einen Wert von ρₛ - 800 Ω/sq erreicht werden. Mit diesem Wert für den Flächenwiderstand ρₛ ergibt sich in Figur 4A ein günstiger Kontaktabstand a von zirka 12,5 µm.

Aus Figur 6A ergibt sich für die ZnO-Schicht 31 eine minimale Dicke im Bereich von 40 nm, für die ITO-Schicht 32 eine minimale Dicke im Bereich von 30 nm und für die IZO-Schicht 33 eine minimale Dicke im Bereich von 15 nm.

Figur 6B zeigt die Auskoppeleffizienz E von Leuchtdiodenchips in Abhängigkeit von der Dicke b der TCO-Schicht. Dabei wurden Leuchtdiodenchips mit unterschiedlichen TCO-Schichten und mit unterschiedlichen Wellenlängen der erzeugten Strahlung betrachtet. Die Auskoppeleffizienz E ist für ZnO- (310, 311, 312), ITO- (320, 321, 322) und IZO-Schichten (330, 331, 332) und für Strahlung mit einer Wellenlänge von 440 nm (310, 320, 330), 460 nm (311, 321, 331) und 530 nm (312, 322, 332) aufgetragen. Insgesamt ist die Auskoppeleffizienz E bei der ZnO-Schicht am größten. Bei zunehmender Schichtdicke b verringert sich die Auskoppeleffizienz E. Bei zunehmender Wellenlänge der Strahlung erhöht sich die Auskoppeleffizienz E. Zusätzlich sind hier die aus Figur 6A ermittelten minimalen Dicken 313, 323, 333 eingetragen.

Die Erfindung ist nicht durch die Beschreibung anhand der Ausführungsbeispiele auf diese beschränkt aober durch die beigefügten Patentansprüche definiert.

## Patentansprüche

1. Leuchtdiodenchip
mit einer Halbleiterschichtenfolge (2), die eine aktive Zone (21) zur Erzeugung elektromagnetischer Strahlung aufweist, mit einer Stromaufweitungsschicht (3), die an die Halbleiterschichtenfolge (2) grenzt,
mit Kontakten (5), die die Stromaufweitungsschicht (3) elektrisch kontaktieren,
wobei die Kontakte (5) zwischen zumindest 1 % und höchstens 8 % der Fläche der Stromaufweitungsschicht (3) bedecken, **dadurch gekennzeichnet, dass** die Wärmeleitfähigkeit der Kontakte (5) mit zunehmendem Abstand von der Halbleiterschichtenfolge (2) zunimmt, und die Querschnittsflächen (D) der Kontakte (5) mit zunehmendem Abstand von der Halbleiterschichtenfolge (2) anwachsen.

2. Leuchtdiodenchip nach Anspruch 1,
bei dem die Kontakte (5) eine konische Form aufweisen.

3. Leuchtdiodenchip nach einem der vorherigen Ansprüche,
bei dem die Kontakte (5) gleichmäßig über die Fläche der Stromaufweitungsschicht (3) verteilt sind.

4. Leuchtdiodenchip nach einem der vorherigen Ansprüche,
bei dem der Abstand benachbarter Kontakte (5) geringer als 30 µm ist.

5. Leuchtdiodenchip nach einem der vorherigen Ansprüche,
bei dem die Kontakte (5) aus separaten Kontaktpunkten (51) bestehen.

6. Leuchtdiodenchip nach einem der vorherigen Ansprüche,
bei dem die Kontakte (5) an Knotenpunkten eines regelmäßigen Gitters (52) angeordnet sind.

7. Leuchtdiodenchip nach einem der vorherigen Ansprüche,
bei dem die Stromaufweitungsschicht (3) eine Dicke (b) im Bereich von wenigstens 10 nm bis höchstens 60 nm aufweist.

8. Leuchtdiodenchip nach einem der vorherigen Ansprüche,
bei dem die Stromaufweitungsschicht (3) Indiumzinkoxid enthält und eine Dicke (b) von mindestens 15 nm aufweist.

9. Leuchtdiodenchip nach einem der vorherigen Ansprüche,
bei dem die Stromaufweitungsschicht (3) Indiumzinnoxid enthält und eine Dicke (b) von mindestens 30 nm aufweist.

10. Leuchtdiodenchip nach einem der vorherigen Ansprüche,
bei dem die Stromaufweitungsschicht (3) Zinkoxid enthält und eine Dicke (b) von mindestens 40 nm aufweist.

11. Leuchtdiodenchip nach einem der vorherigen Ansprüche,
bei dem die Kontakte (5) durch eine dielektrische Schicht (4), insbesondere eine Luftschicht, hindurchführen.

12. Leuchtdiodenchip nach einem der Ansprüche 1 bis 11,
bei dem die Kontakte (5) mit einer Metallschicht (63) elektrisch verbunden sind, die die dielektrische Schicht (4) in Richtung eines Trägers (6) abschließt.

## Claims

1. A light-emitting diode chip
comprising a semiconductor layer sequence (2), which has an active zone (21) for generating electromagnetic radiation,
comprising a current spreading layer (3) adjoining the semiconductor layer sequence (2),
comprising contacts (5) that electrically contact the current spreading layer (3),
wherein the contacts (5) cover between at least 1% and at most 8% of the area of the current spreading layer (3),
**characterized in that**
the thermal conductivity of the contacts (5) increases with increasing distance from the semiconductor layer sequence (2), and the cross-sectional areas (D) of the contacts (5) increase with increasing distance from the semiconductor layer sequence (2).

2. The light-emitting diode chip according to claim 1,
wherein the contacts (5) have a conical shape.

3. The light-emitting diode chip according to either of the preceding claims,
wherein the contacts (5) are distributed uniformly over the area of the current spreading layer (3).

4. The light-emitting diode chip according to any of the preceding claims,
wherein the distance between adjacent contacts (5) is less than 30 µm.

5. The light-emitting diode chip according to any of the preceding claims,
wherein the contacts (5) consist of separate contact points (51).

6. The light-emitting diode chip according to any of the preceding claims,
wherein the contacts (5) are arranged at nodes of a regular lattice (52).

7. The light-emitting diode chip according to any of the preceding claims,
wherein the current spreading layer (3) has a thickness (b) in the range of at least 10 nm to at most 60 nm.

8. The light-emitting diode chip according to any of the preceding claims,
wherein the current spreading layer (3) contains indium zinc oxide and has a thickness (b) of at least 15 nm.

9. The light-emitting diode chip according to any of the preceding claims,
wherein the current spreading layer (3) contains indium tin oxide and has a thickness (b) of at least 30 nm.

10. The light-emitting diode chip according to any of the preceding claims,
wherein the current spreading layer (3) contains zinc oxide and has a thickness (b) of at least 40 nm.

11. The light-emitting diode chip according to any of the preceding claims,
wherein the contacts (5) lead through a dielectric layer (4), in particular an air layer.

12. The light-emitting diode chip according to any of claims 1 to 11,
wherein the contacts (5) are electrically connected to a metal layer (63) that terminates the dielectric layer (4) in direction of a carrier (6).

## Revendications

1. Puce pour diode électroluminescente,
avec une succession de couches semi-conductrices (2) présentant une zone active (21) destinée à générer un rayonnement électromagnétique,
avec une couche de propagation du courant (3) adjacente à une succession de couches semi-conductrices (2),
avec des contacts (5) en contact électrique avec la couche de propagation du courant (3),
dans laquelle les contacts (5) recouvrent entre au minimum 1% et au maximum 8% de la surface de la couche de propagation du courant (3),
**caractérisée en ce que**
la conductivité thermique des contacts (5) augmente avec un espacement croissant par rapport à la succession de couches semi-conductrices (2), et les aires de section transversale (D) des contacts (5) augmentent avec un espacement croissant par rapport à la succession de couches semi-conductrices (2).

2. Puce pour diode électroluminescente selon la revendication 1,
dans laquelle les contacts (5) présentent une forme conique.

3. Puce pour diode électroluminescente selon l'une des revendications précédentes,
dans laquelle les contacts (5) sont répartis uniformément sur la surface de la couche de propagation du courant (3).

4. Puce pour diode électroluminescente selon l'une des revendications précédentes,
dans laquelle l'espacement entre des contacts (5) voisins est inférieur à 30 µm.

5. Puce pour diode électroluminescente selon l'une des revendications précédentes,
dans laquelle les contacts (5) sont constitués de points de contact séparés (51).

6. Puce pour diode électroluminescente selon l'une des revendications précédentes,
dans laquelle les contacts (5) sont agencés sur des points nodaux d'une grille régulière (52).

7. Puce pour diode électroluminescente selon l'une des revendications précédentes,
dans laquelle la couche de propagation du courant (3) présente une épaisseur (b) comprise entre 10 nm au minimum et 60 nm au maximum.

8. Puce pour diode électroluminescente selon l'une des revendications précédentes,
dans laquelle la couche de propagation du courant (3) contient de l'oxyde d'indium et d'étain et présente une épaisseur (b) d'au moins 15 nm.

9. Puce pour diode électroluminescente selon l'une des revendications précédentes,
dans laquelle la couche de propagation du courant (3) contient de l'oxyde d'indium et d'étain et présente une épaisseur (b) d'au moins 30 µm.

10. Puce pour diode électroluminescente selon l'une des revendications précédentes,
dans laquelle la couche de propagation du courant (3) contient de l'oxyde de zinc et présente une épaisseur (b) d'au moins 40 nm.

11. Puce pour diode électroluminescente selon l'une des revendications précédentes,
dans laquelle les contacts (5) traversent une couche diélectrique (4), en particulier une couche d'air.

12. Puce pour diode électroluminescente selon l'une des revendications 1 à 11,
dans laquelle les contacts (5) sont reliés électriquement à une couche métallique (63) fermant la couche diélectrique (4) dans direction d'un support (6).
